# EUROPEAN PATENT APPLICATION

(11) **EP 2 590 234 A1**
(43) Date of publication of application: **08.05.2013**
(21) Application number: 12191106.9
(22) Date of filing: 02.11.2012
(51) Int. Cl.: H01L 33/38

(54) **Solid state light emitting semiconductor device**

(30) Priority: 04.11.2011 TW 100140434
(71) Applicant: Lextar Electronics Corp., 30075 Hsinchu (TW)
(72) Inventor: Chen, Cheng-Hung, 330 Taoyuan County (TW); Hou, Chia-Hung, 806 Kaohsiung City (TW); Hsia, Der-Lin, 238 New Taipei City (TW)
(74) Representative: von Kreisler Selting Werner

(57) **Abstract**

A solid state light emitting semiconductor device including a substrate, a mesa epitaxy stacking structure, an insulating layer, a first type electrode and a second type electrode is provided. The mesa epitaxy stacking structure includes a first type semiconductor layer, an active layer and a second type semiconductor layer arranged in order. A concave area is formed in the middle of the mesa epitaxy stacking structure to expose a portion of the first type semiconductor layer. The insulating layer covers the exposed surface of the first type semiconductor layer around the mesa epitaxy structure, sidewalls of the mesa epitaxy stacking structure and a portion of surface of the second type semiconductor layer. The first type electrode is located on the exposed first type semiconductor layer in the concave area, and is surrounded by the second type electrode located on the insulating layer around the mesa epitaxy stacking structure.

## Description

### BACKGROUND OF THE INVENTION

### Field of the Invention

The invention relates in general to a semiconductor device, and more particularly to a solid state light emitting semiconductor device.

### Description of the Related Art

The light-emitting diode (LED) emits a light by converting electric energy into photo energy. The LED is mainly composed of semiconductors. Of the semiconductors, those having a larger ratio of holes carrying positive electricity are referred as P type semiconductors, and those having a larger ratio of electrons carrying negative electricity are referred as N type semiconductors. The joint connecting a P type semiconductor and an N type semiconductor forms a PN junction. When a voltage is applied to the positive polarity and negative polarity of an LED, the electrons and the holes will be combined and emitted in the form of light.

In addition, the luminous intensity of LED is related to the current density of a voltage applied thereto. In general, the luminous intensity increases with the increase in the current density. However, it is not easy to increase the light extraction efficiency and at the same time make the current uniformly diffused. In a conventional method, the current can be uniformly diffused by extending the electrodes. By doing so, the light emitting area is reduced and the luminous intensity deteriorates accordingly. Conversely, if the luminous intensity is increased by reducing the light blocking area of the electrodes, the current cannot be diffused uniformly and the effect of heat concentration will be worsened. Therefore, how to make the current density uniformly distributed without affecting the luminous intensity has become a prominent task for the industries.

### SUMMARY OF THE INVENTION

The invention is directed to a solid state light emitting semiconductor device capable of reducing the light blocking area for the electrode and uniformly diffusing the current so as to increase the luminous intensity for the light emitting semiconductor device.

According to an embodiment of the present invention, a solid state light emitting semiconductor device including a substrate, a mesa epitaxy stacking structure, an insulating layer, a first type electrode and a second type electrode is provided. The mesa epitaxy stacking structure is formed on the substrate. The mesa epitaxy stacking structure includes a first type semiconductor layer, an active layer and a second type semiconductor layer which are arranged in order from the substrate, wherein a portion of surface of the first type semiconductor is exposed around the mesa epitaxy stacking structure, and a concave area is formed in the middle of the mesa epitaxy stacking structure to expose a portion of the first type semiconductor layer. The insulating layer covers the exposed surface of the first type semiconductor layer around the mesa epitaxy structure, sidewalls of the mesa epitaxy stacking structure and a portion of surface of the second type semiconductor layer. The first type electrode is located on the exposed first type semiconductor layer in the concave area. The second type electrode is located on the insulating layer around the mesa epitaxy stacking structure, so that the first type electrode is surrounded by the second type electrode.

The above and other aspects of the invention will become better understood with regard to the following detailed description of the preferred but non-limiting embodiments. The following description is made with reference to the accompanying drawings.

### BRIEF DESCRIPTION OF THE DRAWINGS

FIG. 1 shows a top view of a solid state light emitting semiconductor device according to an embodiment of the invention;

FIG. 2A shows a cross-sectional view of the solid state light emitting semiconductor device of FIG. 1 along a cross-sectional line A-A;

FIG. 2B shows a cross-sectional view of the solid state light emitting semiconductor device of FIG. 1 along a cross-sectional line B-B;

FIG. 2C shows a cross-sectional view of the solid state light emitting semiconductor device of FIG. 1 along a cross-sectional line C-C;

FIGS. 3A∼3D are cross-sectional views showing a manufacturing process of the solid state light emitting semiconductor device of FIG. 1 along a cross-sectional line B-B;

FIGS. 4A∼4D are cross-sectional views showing a manufacturing process of the solid state light emitting semiconductor device of FIG. 1 along a cross-sectional line C-C.

### DETAILED DESCRIPTION OF THE INVENTION

The solid state light emitting semiconductor device of the present embodiment transmits the current to the mesa epitaxy stacking structure with a strip-shaped first type electrode and a second type electrode surrounding the first type electrode for uniformly diffusing the current, so as to resolve the problem of current crowding or non-uniform density, and further increase the internal quantum efficiency and light extraction efficiency of the light emitting semiconductor device. Since the light blocking area of the second type electrode is reduced to minimum, the light emitting area is increased and the luminous intensity of the light emitting semiconductor device is improved accordingly.

A number of embodiments are disclosed below for elaborating the invention. However, the embodiments of the invention are for detailed descriptions only, not for limiting the scope of protection of the invention.

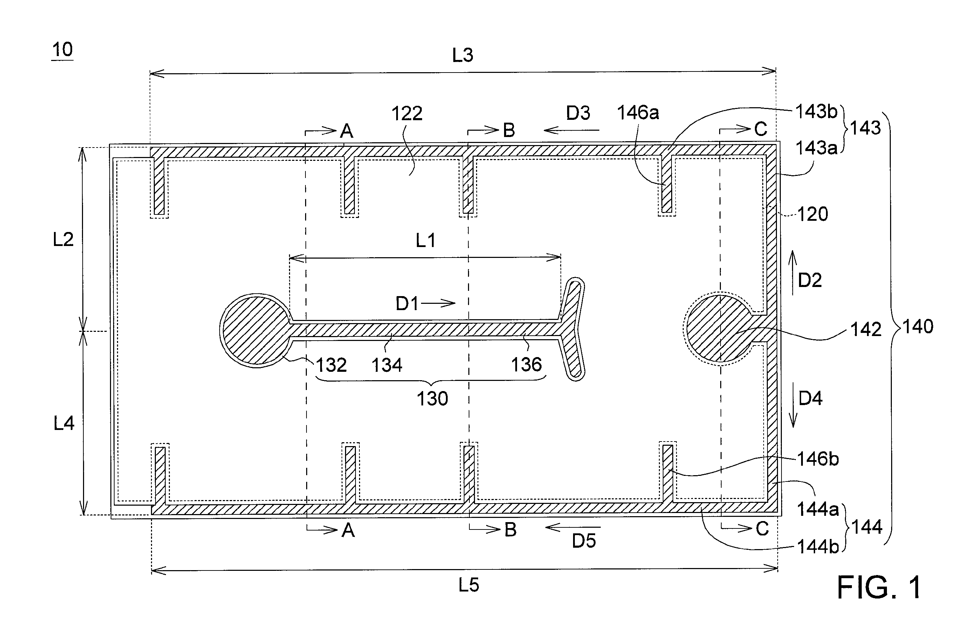

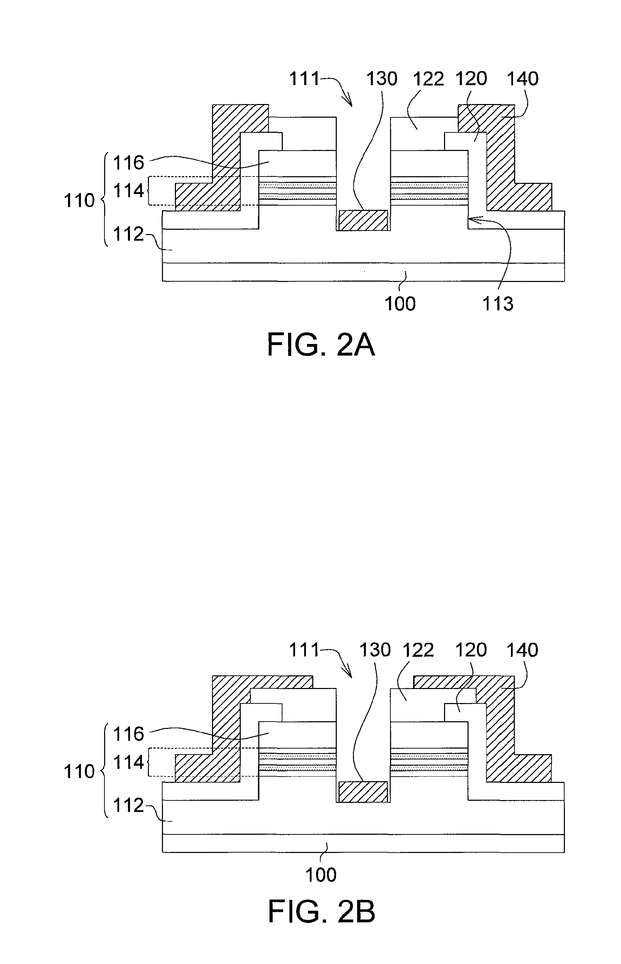

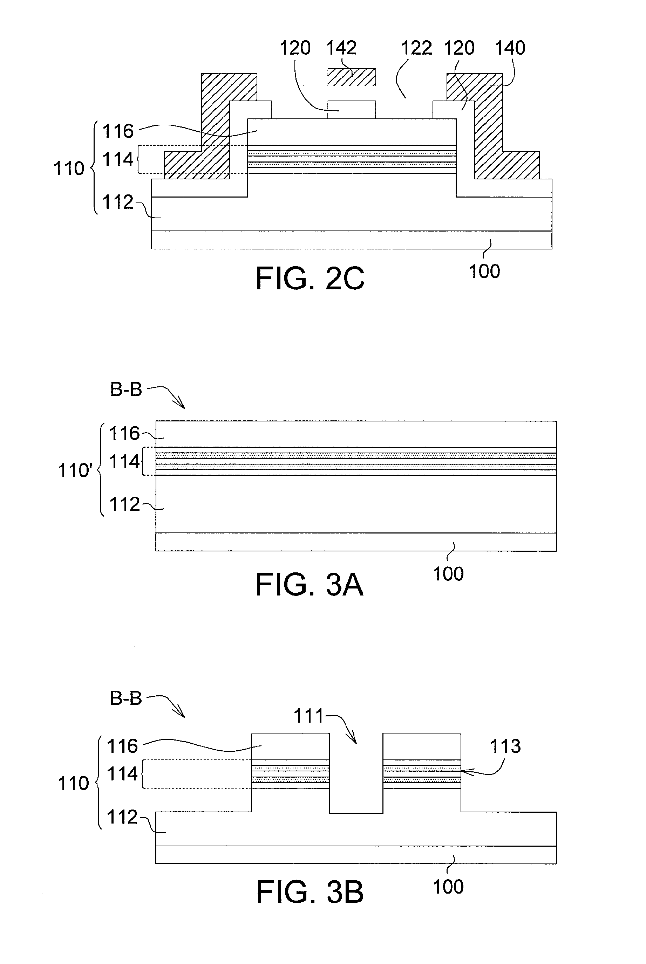

Referring to FIGS. 1 and 2A∼2C. FIG. 1shows a top view of a solid state light emitting semiconductor device according to an embodiment of the invention. FIG. 2A shows a cross-sectional view of the solid state light emitting semiconductor device of FIG. 1 along a cross-sectional line A-A. FIG 2B shows a cross-sectional view of the solid state light emitting semiconductor device of FIG. 1 along a cross-sectional line B-B. FIG. 2C shows a cross-sectional view of the solid state light emitting semiconductor device of FIG. 1 along a cross-sectional line C-C.

The solid state light emitting semiconductor device 10 includes a substrate 100, a mesa epitaxy stacking structure 110, an insulating layer 120, a transparent conductive layer 122, a first type electrode 130 (referring to FIG. 2A and 2B) and a second type electrode 140 (referring to FIG. 2C). The mesa epitaxy stacking structure 110 is formed on the substrate 100. The mesa epitaxy stacking structure 110 includes a first type semiconductor layer 112, an active layer 114 and a second type semiconductor layer 116 arranged in order from the end contacting the substrate 100. The first type semiconductor layer 112 may be an N-type semiconductor layer, and the second type semiconductor layer 116 may be a P-type semiconductor layer. In another embodiment, the first type semiconductor layer 112 may be a P-type semiconductor layer, and the second type semiconductor layer 116 may be an N-type semiconductor layer. The active layer 114 can include multi-quantum well layers. The first type semiconductor layer 112, the active layer 114 and the second type semiconductor layer 116 may be formed by a nitride contained the elements of group IIIA of the periodic table, such as aluminum nitride, gallium nitride or indium gallium nitride. Therefore, when a voltage is applied to the first type semiconductor layer 112 and the second type semiconductor layer 116, the electrons and the holes of the active layer 114 will be combined and emitted in the form of light. The transparent conductive layer 122 is formed by indium tin oxide (ITO) or indium zinc oxide (IZO), for example.

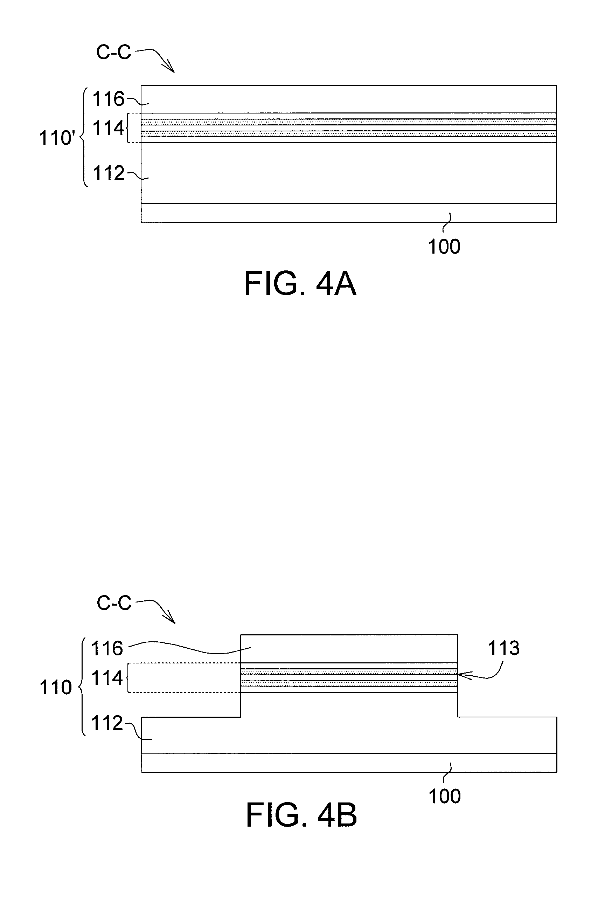

In the present embodiment, a mesa structure is formed around the mesa epitaxy stacking structure 110 to expose a portion of the surface of the first type semiconductor layer 112. A concave area is formed in the middle 111 (referring to FIGS. 2A and 2B) of the mesa epitaxy stacking structure 110 to expose a portion of the first type semiconductor layer 112. Details of the manufacturing process of the mesa epitaxy stacking structure 110 are disclosed with accompanying drawings FIGS. 3A∼3B and FIGS. 4A∼4B.

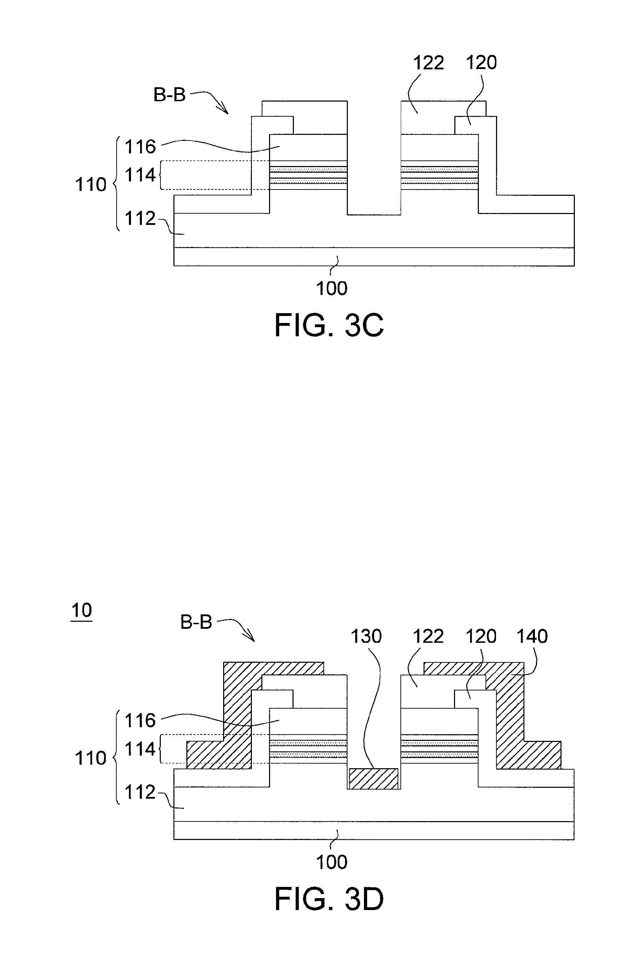

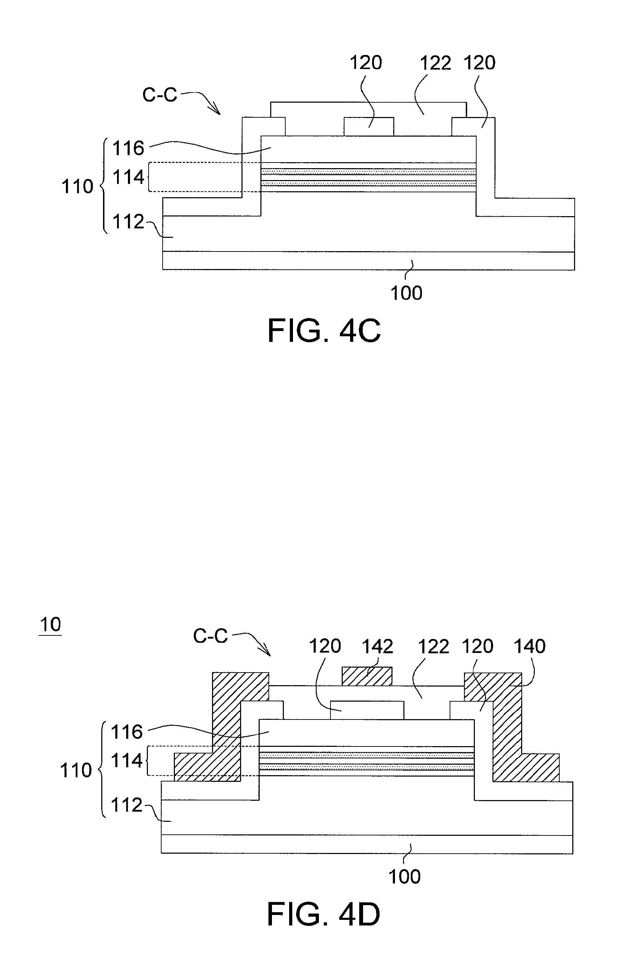

Moreover, the insulating layer 120 covers the exposed surface of first type semiconductor layer 112 around the mesa epitaxy stacking structure 110, the sidewall 113 of the mesa epitaxy stacking structure 110 and a portion of the surface of the second type semiconductor layer 116. The insulating layer 120 may be formed by an oxide containing silicon (SiOx) such as silicon dioxide or a nitride containing silicon (SiNx) such as silicon nitride, so that the first type semiconductor layer 112, the second type semiconductor layer 116 and the second type electrode 140 are electrically isolated from each other. In addition, a transparent conductive layer 122 may be disposed between the second type electrode 140 and the second type semiconductor layer 116 for electrically connecting the second type electrode 140 and the second type semiconductor layer 116. Details of the manufacturing process of the insulating layer 120 and the transparent conductive layer 122 are disclosed with accompanying drawings FIG. 3C and FIG. 4C.

As indicated in FIGS. 2A and 2B, the first type electrode 130 is located on the exposed first type semiconductor layer 112 in the concave area 111. As indicated in FIG. 2C, the second type electrode 140 is located on the insulating layer 120 around the mesa epitaxy stacking structure 110, so that the first type electrode 130 is surrounded by the second type electrode140. In an embodiment, the first type electrode 130 may be electrically connected to a bonding wire (not illustrated), and the second type electrode 140 may be electrically connected to another bonding wire (not illustrated), so that the solid state light emitting semiconductor device 10 may be excited by the electric energy transmitted via the bonding wires to emit a light. Details of the manufacturing process of the first type electrode 130 and the second type electrode 140 are disclosed with accompanying drawings FIGS. 3D and FIG. 4D.

Referring to FIG. 1, the first type electrode 130 includes a first pad 132, a first extension portion 134 and an end portion 136. The first pad 132 is disposed on the exposed first type semiconductor layer 112 in the concave area 111. The first extension portion 134 extends a first distance L1 from the first pad 132 along a first direction D1. The end portion 136 is disposed at the tail of the first extension portion 134, and the tangent line (not illustrated) on any point of the end portion 136 intersects the first extension portion 134. The shape of the end portion 136 is linear, V-shaped, arced, parabolic, Y-shaped, concave, semicircular, curved or geometric, for example. In the present embodiment, the end portion 136 extends outwards to form an arc from two opposite sides of the first extension portion 134.

Besides, the second type electrode 140 includes a second pad 142, a second extension portion 143 and a third extension portion 144. As indicated in FIG. 2C, the second pad 142 is disposed on the insulating layer 120 around the mesa epitaxy stacking structure 110. As indicated in FIG. 1, the second pad 142 is located on the part of the extension line of the first extension portion 134 corresponding to the end portion 136.

As indicated in FIG. 1, the second extension portion 143 includes a first extension segment 143a and a second extension segment 143b. The first extension segment 143a extends a second distance L2 from the second pad 142 along a second direction D2. The second extension segment 143b connects the first extension segment 143a, and extends a third distance L3 along a third direction D3. The third distance L3 may be larger than the first distance L1.

As indicated in FIG. 1, the third extension portion 144 includes a third extension segment 144a and a fourth extension segment 144b. The third extension segment 144a extends a fourth distance L4 rom the second pad 142 along a fourth direction D4. The fourth extension segment 144b connects the third extension segment 144a, and extends a fifth distance L5 along a fifth direction D5. The third distance L3 may be larger than the first distance L1.

In the present embodiment, the third direction D3 and the fifth direction D5 are respectively opposite to the first direction D1 by 180 degrees. The second direction D2 and the fourth direction D4 are opposite to each other by 180 degrees and are respectively perpendicular to the third direction D3 and the fifth direction D5. Therefore, the first type electrode 130 located on the concave area 111 is surrounded by the second extension portion 143 and the third extension portion 144 of the second type electrode 140 to improve the non-uniform distribution of the current. Since the light blocking area of the second type electrode 140 is reduced, the luminous intensity of the light emitting semiconductor element 10 is thus increased.

Furthermore, to make the current uniformly distributed, the second extension segment 143b and the fourth extension segment 144b of the second type electrode 140 respectively include multiple first finger portion structures 146a and multiple second finger portion structures 146b extended towards the first type electrode 130. In the present embodiment, the first and the second finger portion structures 146a and 146b are respectively perpendicular to the second and the fourth extension segments 143b and 144b. Since the first finger portion structures 146a and the second finger portion structures 146b are distributed like branches, the current can thus be uniformly diffused inwardly via the branches. In addition, the branch distribution makes the light blocking area of the second type electrode 140 minimized, so that the light emitting area is increased and the luminous intensity is improved accordingly.

A method of manufacturing a solid state light emitting semiconductor device is disclosed below. FIGS. 3A∼3D are cross-sectional views showing a manufacturing process of the solid state light emitting semiconductor device of FIG. 1 along a cross-sectional line B-B. FIGS. 4A∼4D are cross-sectional views showing a manufacturing process of the solid state light emitting semiconductor device of FIG. 1 along a cross-sectional line C-C.

Referring to FIGS. 3A and 4A. Firstly, a first type semiconductor layer 112, an active layer 114 and a second type semiconductor layer 116 are sequentially grown to form an epitaxy stacking structure 110' on the substrate 100. Next, as indicated in FIG. 3B and FIG. 4B, anisotropic etching is performed to form a mesa epitaxy stacking structure 110, wherein a portion of the surface of the first type semiconductor layer 112 is exposed around the mesa epitaxy stacking structure 110 and a concave area 111 is formed in the middle of the mesa epitaxy stacking structure 110 to expose a portion of the first type semiconductor layer 112. Then, as indicated in FIGS. 3C and 4C, an insulating layer 120 is formed to cover the exposed surface of first type semiconductor layer 112 around the mesa epitaxy stacking structure 110, the sidewall 113 of the mesa epitaxy stacking structure 110 and a portion of the surface of the second type semiconductor layer 116. Then, a transparent conductive layer 122 is formed on a portion of the surface of second type semiconductor layer 116 not covered by the insulating layer 120. Then, as indicated in FIGS. 3D and 4D, a first type electrode 130 is formed on the exposed first type semiconductor layer 112 in the concave area 111, and a second type electrode 140 is formed on the insulating layer 120 around the mesa epitaxy stacking structure 110, so that the first type electrode 130 is surrounded by the second type electrode140. Since the first type electrode 130 located in the concave area 111 may be surrounded by the second type electrode140, the problem of non-uniform distribution of the current is resolved, and the light blocking area of the second type electrode 140 is reduced. Consequently, the luminous intensity of the light emitting semiconductor device is increased.

While the invention has been described by way of example and in terms of the preferred embodiment(s), it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A solid state light emitting semiconductor device, comprising:
a substrate;
a mesa epitaxy stacking structure formed on the substrate and comprising a first type semiconductor layer, an active layer and a second type semiconductor layer which are arranged in order from the substrate, wherein a portion of surface of the first type semiconductor layer is exposed around the mesa epitaxy stacking structure, and a concave area is formed in the middle of the mesa epitaxy stacking structure to expose a portion of the first type semiconductor layer;
an insulating layer covering the exposed surface of the first type semiconductor layer around the mesa epitaxy stacking structure, sidewalls of the mesa epitaxy stacking structure and a portion of surface of the second type semiconductor layer ;
a first type electrode located on the exposed first type semiconductor layer in the concave area; and
a second type electrode located on the insulating layer around the mesa epitaxy stacking structure, so that the first type electrode is surrounded by the second type electrode.

2. The solid state light emitting semiconductor device according to claim 1, wherein the first type electrode comprising:
a first pad disposed on the exposed first type semiconductor layer in the concave area;
a first extension portion extending a first distance from the first pad along a first direction; and
an end portion disposed at a tail of the first extension portion.

3. The solid state light emitting semiconductor device according to claim 2, wherein the second type electrode comprises:
a second pad disposed on the insulating layer around the mesa epitaxy stacking structure and located on a part of extension line of the first extension portion corresponding to the end portion;
a second extension portion comprising a first extension segment extending a second distance from the second pad along a second direction, and a second extension segment connecting the first extension segment and extending a third distance along a third direction; and
a third extension portion comprising a third extension segment extending a fourth distance from the second pad along a fourth direction, and a fourth extension segment connecting the third extension segment and extending a fifth distance along a fifth direction;
wherein the third and the fifth directions are opposite to the first direction by 180 degrees, while the second and the fourth directions are opposite to each other by 180 degrees and are respectively perpendicular to the third and the fifth directions.

4. The solid state light emitting semiconductor device according to claim 3, wherein the second and the fourth extension segments respectively comprises a plurality of first and second finger portion structures extending towards the first type electrode.

5. The solid state light emitting semiconductor device according to claim 4, wherein the first and the second finger portion structures are respectively perpendicular to the second and the fourth extension segments.

6. The solid state light emitting semiconductor device according to claim 1, further comprising a transparent conductive layer located between the second type electrode and the second type semiconductor layer.

7. The solid state light emitting semiconductor device according to claim 6, wherein material of transparent conductive layer is indium tin oxide (ITO) or indium zinc oxide (IZO).

8. The solid state light emitting semiconductor device according to claim 1, wherein the first type semiconductor layer is an N-type semiconductor layer, and the second type semiconductor layer is a P-type semiconductor layer.

9. The solid state light emitting semiconductor device according to claim 1, wherein the first type electrode is an N-type electrode, and the second type electrode is a P-type electrode.

10. The solid state light emitting semiconductor device according to claim 3, wherein the third distance and the fifth distance both are larger than the first distance.

11. The solid state light emitting semiconductor device according to claim 3, wherein the first electrode is located within a region surrounded by the second and the third extension portions of the second electrode.

12. The solid state light emitting semiconductor device according to claim 2, wherein the shape of the end portion is linear, V-shaped, arced, parabolic, Y-shaped, concave, semicircular, curved or geometric.

13. The solid state light emitting semiconductor device according to claim 2, wherein a tangent line to any points on the end portion intersects the first extension portion.
